# FASCICULE DE BREVET EUROPEEN

(11) **EP 3 682 482 B1**
(45) Date de publication et mention de la délivrance du brevet: **10.08.2022**
(21) Numéro de dépôt: 18780179.0
(22) Date de dépôt: 11.09.2018
(51) Int. Cl.: H01L 29/778, H01L 29/16, H01L 29/24, H01L 21/336, G01N 27/414

(54) **TRANSISTORS A EFFET DE CHAMP AVEC UN CANAL MINCE ATOMIQUE**
FELDEFFEKTTRANSISTOR MIT EINEM ATOMISCH DÜNNEN KANAL
FIELD EFFECT TRANSISTOR WITH AN ATOMICALLY THIN CHANNEL

(30) Priorité: 15.09.2017 FR 1758588
(43) Date de publication de la demande: 22.07.2020
(73) Titulaire: Commissariat à l'énergie atomique et aux énergies alternatives, 75015 Paris (FR)
(72) Inventeur: ALAVA, Thomas, 38000 Grenoble (FR); ERNST, Thomas, 38210 Morette (FR); HAN, Zheng, 38360 Noyarey (FR)
(74) Mandataire: Brevalex
(86) Numéro de dépôt international: PCT/FR2018/052211
(87) Numéro de publication internationale: WO 2019/053362

(56) Documents cités:
- WO-A1-2014/197857
- KR-A- 20110 018 851
- US-A1- 2013 214 332
- US-A1- 2015 050 800

## Description

### DOMAINE TECHNIQUE

La présente invention a trait au domaine des transistors de type communément appelé finFET dans lesquels la structure de canal est formée d'au moins un barreau, encore appelé ailette (« fin » selon la terminologie anglo-saxonne) qui s'étend sur un substrat avec au moins une électrode grille qui peut être agencée sur plusieurs faces de l'ailette et/ou avoir une répartition enrobante autour de l'ailette.

Elle concerne la mise en oeuvre de transistors à une ou plusieurs ailettes de dimension critique très faible, en particulier inférieure à 10 nm nanomètres, et peut s'appliquer notamment à la réalisation de capteurs tels que des capteurs biologiques ou des capteurs de gaz dotés de tels transistors et dont la sensibilité est améliorée.

### ART ANTÉRIEUR

D'une manière générale on cherche constamment à réduire les dimensions des transistors, notamment pour améliorer leur densité d'intégration.

Le document « MoS2 transistors with 1-nanometer gate lengths » de Sujay B. Desai et al. Science 354 (2016) 99-102, présente par exemple un transistor de dimensions très réduites et doté en particulier d'une longueur de grille de l'ordre de 1 nm, et qui se présente sous la forme d'un nano-tube. La structure de canal n'est ici pas sous forme d'une ailette mais d'une couche en MoS₂ agencée sur le nano-tube.

En même temps que l'on souhaite réduire les dimensions des transistors, on cherche également à améliorer leurs performances électriques.

Un transistor de type finFET permet notamment de par sa structure à ailette(s) de pouvoir réaliser un meilleur contrôle électrostatique du canal.

Dans le domaine des transistors à ailette, le document « Hybrid Si/TMD 2D Electronic Double Channels Fabricated Using Solid CVD Few Layer-MoS₂ stacking for Vth Matching and CMOS-compatible 3DFETs », de Chen et al. IEDM 2014, présente par exemple une structure de canal améliorée sous forme d'une ailette en silicium enrobée d'une fine couche de matériau semi-conducteur 2D comprenant entre 3 et 16 mono-couches moléculaires de MoS₂. Une telle structure d'ailette à laquelle on adjoint la fine couche de matériau semi-conducteur 2D permet d'obtenir des performances électriques améliorées notamment en termes de courant de conduction. Toutefois, les dimensions de la structure de canal dépendent ici principalement de celles de l'ailette en silicium, dont la taille est généralement imposée par les procédés de lithographie actuellement disponibles.

Le document WO2014/197857 A1 concerne un procédé de réalisation d'un transistor dont la structure de canal comporte des ailettes, comprenant le dépôt d'une couche qui formera les ailettes sur les côtés de blocs de support en présence d'un masque utilisé auparavant pour former lesdits blocs par gravure.

Il se pose le problème de mettre en oeuvre un transistor ayant une structure de canal à ailette et dont les dimensions sont davantage réduites.

### EXPOSÉ DE L'INVENTION

Un but de la présente invention est de proposer un procédé de réalisation d'un transistor avec une ou plusieurs ailettes de dimension critique très réduite, en particulier inférieure à 10 nanomètres et de préférence inférieure ou égale à 3 nm, tout en ayant de bonne propriétés électriques.

Pour cela, la présente invention propose selon un mode de réalisation, un procédé selon la revendication 1 de réalisation d'un transistor dont la structure de canal comporte une ou plusieurs ailette(s), le procédé comprenant en particulier:
- formation sur un substrat d'un ou plusieurs blocs appelés « blocs de moulage »,
- formation sur lesdits un ou plusieurs blocs de moulage d'une couche à base d'un matériau donné, semi-conducteur ou semi-métallique, cette couche appelée « fine couche » étant constitué d'au plus dix mono-couche(s) ou feuillets atomique(s) ou moléculaire(s) de cristal bidimensionnel,
- retrait desdits un ou plusieurs blocs de moulage tout en conservant une ou plusieurs portion(s) de la fine couche s'étendant contre au moins une face latérale desdits bloc de moulage, lesdites une ou plusieurs portions conservées formant une ou plusieurs ailette(s) apte(s) à former une structure de canal du transistor,
- réaliser une électrode de grille contre lesdites une ou plusieurs ailette(s).

Ainsi, la ou les ailettes ont une dimension critique qui ne dépend pas d'un procédé de lithographie mais qui correspond à l'épaisseur déposée.

De préférence, la fine couche est constitué de une à cinq mono-couche(s) atomique(s) ou moléculaire(s) de cristal bidimensionnel.

Cette épaisseur peut être de l'ordre de la taille d'un atome ou d'une molécule lorsque le cristal bidimensionnel est de manière avantageuse sous forme d'une mono-couche ou d'un mono feuillet.

Avantageusement, le matériau donné de la fine couche est du graphène ou un chalcogénure de métal, en particulier du MoS₂ ou du WS₂ ou du WSe₂ ou du MoSe₂. De tels matériaux permettent de réaliser des ailettes avec un rapport de surface sur volume très important tout en ayant de très bonnes propriétés électriques.

La grille formée sur la ou les ailettes est de préférence une grille enrobante, qui peut être répartie autour d'une portion de la ou des ailettes sur plusieurs plans différents.

La fine couche est formée par croissance catalytique, lesdits un ou plusieurs blocs de moulage étant à base d'un matériau catalytique pour la croissance dudit matériau donné.

Selon une possibilité de mise en oeuvre, les blocs de moulage peuvent être en un matériau diélectrique, en particulier du SiO₂.

Le procédé comprend préalablement au retrait des blocs de moulage la formation d'un ou plusieurs blocs appelés « blocs de maintien » respectivement situés à une ou plusieurs extrémités des blocs de moulage, lesdits un ou plusieurs blocs de maintien étant adaptés pour assurer une tenue mécanique desdites une ou plusieurs ailette(s) lors du retrait desdits un ou plusieurs blocs de moulage.

De préférence, les électrodes de source et de drain du transistor remplissent la fonction de blocs de maintien.

Avantageusement, les électrodes de source et de drain sont à base d'un matériau conducteur tandis que lesdits un ou plusieurs blocs de moulage sont formés à base d'un matériau apte à être gravé sélectivement vis-vis dudit matériau conducteur.

Selon une possibilité de mise en oeuvre du procédé, afin de pouvoir graver les blocs de moulage sans retirer l'ensemble de la fine couche, après formation de la fine couche et préalablement au retrait des blocs de moulage le procédé peut comprendre des étapes de :
- formation d'un masquage recouvrant les blocs de moulage,
- retrait d'une épaisseur du masquage de sorte à dévoiler une partie supérieure des blocs de moulage.

Selon une mise en oeuvre particulière du procédé dans lequel la grille est une grille enrobante réalisée par formation d'un empilement de grille comprenant au moins une couche de diélectrique de grille et au moins une couche de matériau de grille, le procédé peut comprendre en outre le retrait localisé d'une ou plusieurs zones de la grille enrobante de sorte à dévoiler une ou plusieurs régions données desdites une ou plusieurs ailettes.

Après le retrait localisé de sorte à retirer des zones de l'empilement de grille, on peut former sur les régions données dévoilées desdites une ou plusieurs ailettes au moins une couche de capture à base d'un matériau apte à absorber et/ou adsorber au moins une espèce chimique.

Selon un autre aspect, la présente invention prévoit un procédé de fabrication d'un capteur chimique ou biologique doté d'au moins un transistor mis en oeuvre à l'aide d'un procédé tel que défini plus haut.

Selon un autre aspect, la présente invention prévoit un transistor, en particulier de type finFET comprenant :
- une structure de canal dotée d'une ou plusieurs ailette(s) constituée(s) d'un matériau semi-conducteur ou semi-métallique ayant une à dix mono-couche(s) atomique(s) ou moléculaire(s) de cristal bidimensionnel,
- une électrode de grille, enrobante, autour desdites une ou plusieurs ailette(s).

Le matériau donné est typiquement un matériau de type Van der Waals ou un semi-conducteur bidimensionnel.

Le matériau donné peut être en particulier du graphène ou un dichalcogénure de métal de transition.

Avantageusement, le matériau donné peut être formé d'une seule mono-couche (ou feuillet) de Graphène ou bien d'une seule mono-couche (ou feuillet) de dichalcogénure de métal de transition.

Le transistor peut être ainsi muni d'ailettes très fines, de l'épaisseur de l'ordre de l'atome ou d'une molécule tout en conservant de bonnes propriétés électriques.

Le transistor peut être doté d'électrodes de source et de drain disposées respectivement à une première extrémité et à une deuxième extrémité des ailettes, les électrodes de source et de drain étant à base d'un matériau métallique.

Selon un mode de réalisation du transistor, celui-ci peut être formé sur un substrat et comporter au moins une première ailette et au moins une deuxième ailette la première et la deuxième ailette étant parallèles à un plan principal du substrat et orientées dans des directions différentes, la première ailette étant en contact de la deuxième ailette.

Pour certaines applications, le transistor peut être prévu avec une portion des ailettes recouverte par la grille enrobante et une autre par au moins une couche de capture apte à absorber et/ou adsorber au moins une espèce chimique ou biologique.

De par la taille des ailettes, le transistor est particulièrement adapté à la détection de très faibles quantités d'éléments chimiques ou biologiques.

Ainsi, selon un autre aspect, la présente invention concerne un capteur chimique ou biologique doté d'un ou plusieurs transistors à ailette(s) tel(s) que défini(s) plus haut.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A-1G et 2A-2F servent à illustrer un exemple de procédé de réalisation d'un transistor à ailettes de dimensions très réduites et qui peut atteindre celle d'un atome ou d'une molécule ;
- les figures 3A-3B servent à illustrer une variante de procédé de réalisation du transistor à ailette ;
- la figure 4 illustre un exemple de transistor finFET à ailette de dimension très réduite et tel que mis en oeuvre suivant un mode de réalisation de la présente invention ;
- la figure 5 illustre un exemple de transistor à ailette tel que mis en oeuvre suivant un mode de réalisation de la présente invention et doté en outre d'une couche de capture pour la détection de gaz ou d'éléments biologiques ;
- la figure 6 illustre un exemple particulier de transistor à ailettes orthogonales l'une par rapport à l'autre et se rejoignant en au moins un point de contact ;

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

En outre, dans la description ci-après, des termes qui dépendent de l'orientation de la structure tels que « vertical », « horizontal », « inférieur », « latérale », s'appliquent en considérant que la structure est orientée de la façon illustrée sur les figures.

### EXPOSÉ DÉTAILLÉ DE MODES DE RÉALISATION PARTICULIERS

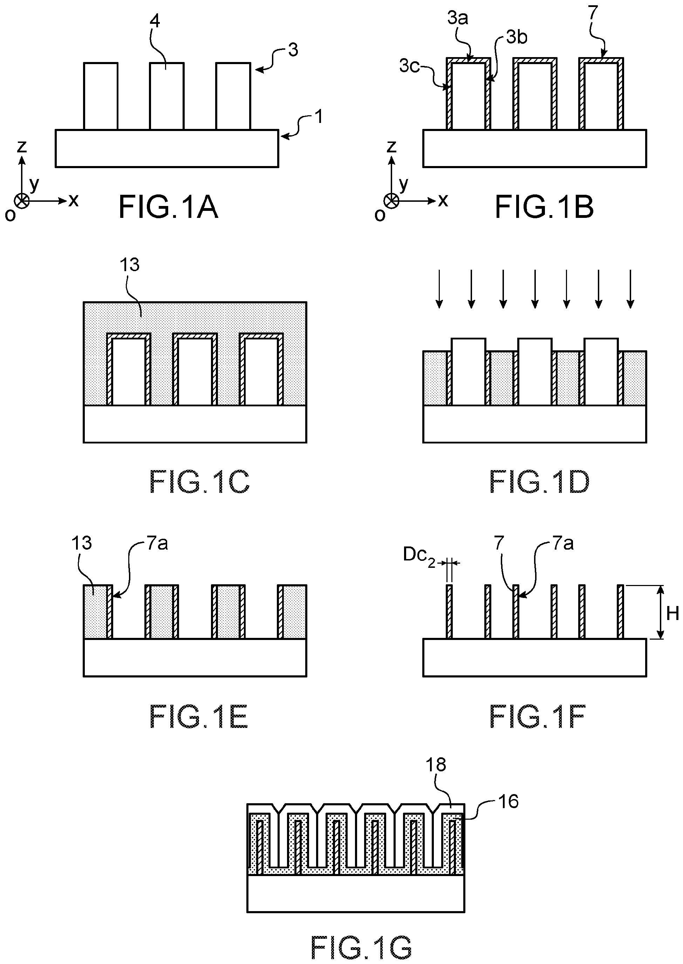

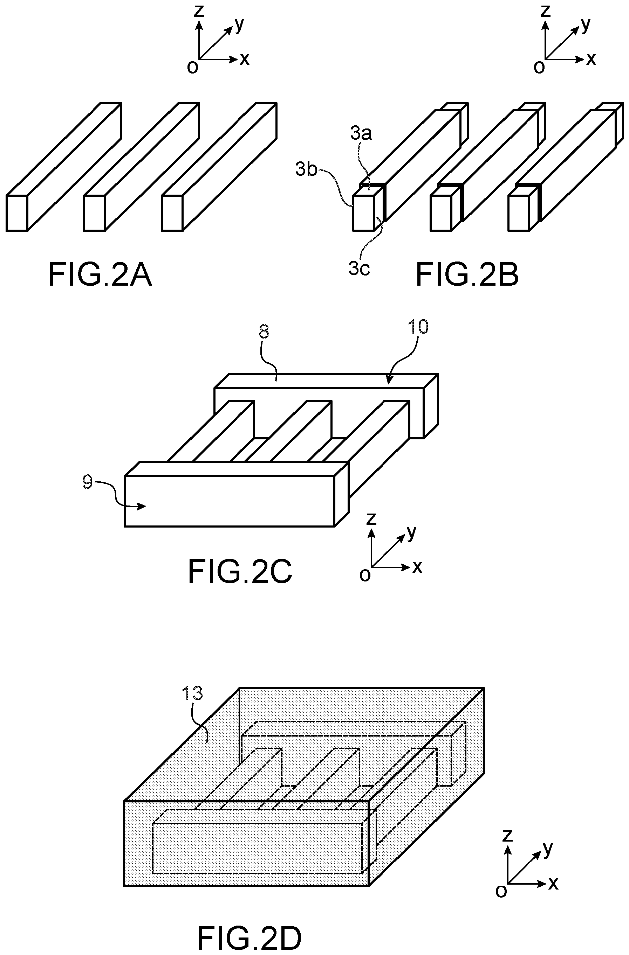

Un exemple de procédé de réalisation d'un transistor, en particulier de type finFET, dont la structure de canal est formée d'une ou plusieurs ailettes de taille nanométrique et tel que mis en oeuvre suivant un mode de réalisation de la présente invention va à présent être décrit en liaison avec les figures 1A-1G (donnant une vue en coupe transversale) et les figures 2A-2F (sur lesquelles la structure en cours de réalisation est représentée selon une vue en perspective).

On peut prévoir comme matériau de départ un substrat massif (« bulk » selon la terminologie anglo-saxonne) semi-conducteur, par exemple en silicium. En variante, on peut également partir d'un substrat 1 de type semi-conducteur sur isolant formé d'une couche de support semi-conductrice, par exemple du silicium, la couche de support étant recouverte d'une couche isolante en matériau diélectrique, typiquement de l'oxyde de silicium, elle-même recouverte d'une couche semi-conductrice superficielle.

Le substrat 1 peut être muni de marques d'alignement, par exemple formées par gravure de parties non-protégées par un masque de résine photosensible ou bien par dépôt de métal puis gravure.

Sur le substrat 1, on réalise tout d'abord un ou plusieurs blocs 3, appelés blocs de moulage (figure 1A) et qui, dans l'exemple particulier illustré sur la figure 2A, sont des blocs longilignes et de forme parallépipédique. On dispose dans cet exemple, plusieurs blocs 3 de moulage parallèlement les uns aux autres, selon un pas prédéterminé, qui peut être compris par exemple entre 10 nm et 100 µm.

Les blocs 3 ont une dimension critique Dc1 comprise typiquement entre 30 nm et 100 µm. La dimension critique Dc1 peut être inférieure à 30 nm, cette dimension correspondant généralement à une dimension limite imposée par les procédés de lithographie actuellement disponibles, en particulier ceux utilisant un faisceau d'électron (e-beam).

Par « dimension critique », on entend la plus petite dimension d'un motif mesurée parallèlement au plan principal du substrat 1. Le « plan principal » est défini comme un plan passant par le substrat 1 et qui est parallèle au plan [O ;x ;y] d'un repère orthogonal [O ;x ;y ; z] donné sur les figures.

Les blocs de moulage 3 peuvent être formés par exemple par dépôt d'une couche à base d'un matériau 4 puis photolithographie et gravure de ce matériau 4 afin de définir des motifs.

En variante, pour réaliser ces blocs 3, on forme des ouvertures dans une couche de masquage, en particulier un masquage en résine photosensible, puis on effectue un remplissage des ouvertures du masquage par un matériau 4. Le masquage est ensuite retiré typiquement au moyen d'un procédé de décapage communément appelé « lift-off » lorsque ce masquage est en résine.

On forme ensuite une fine couche 7 à base de matériau semi-conducteur ou de semi-métal, de préférence de type Van der Waals ou bidimensionnel (2D), à partir de laquelle on prévoit de réaliser la structure de canal du transistor. La fine couche 7 d'épaisseur nano-métrique, est réalisée par croissance sur les blocs 3 de moulage. Par « nano-métrique », on entend une épaisseur inférieure à 10 nanomètres.

Typiquement, la fine couche 7 a une épaisseur inférieure à 3 nm.

La fine couche 7 est en particulier constituée de 1 à 10 mono-couche(s) atomique(s) d'un matériau bidimensionnel (2D) cristallin tel que le graphène ou de 1 à 10 mono-couche(s) moléculaire(s) d'un matériau bidimensionnel (2D) d'un matériau à base de chalcogénures et de métaux de transition.

Par « mono-couche atomique », on entend un feuillet, autrement dit une couche, dont l'épaisseur est constituée d'un seul atome. Par « mono-couche moléculaire » on entend un feuillet, autrement dit une couche, dont l'épaisseur est constituée d'une seule molécule, cette couche étant formée d'un motif répété de molécules liées entre elles par le biais de liaisons covalentes.

De préférence, la fine couche comporte au plus 5 mono-couches atomiques ou moléculaires de matériau bidimensionnel cristallin, en particulier d'un semi-conducteur bidimensionnel encore appelé semi-conducteur 2D.

Avantageusement, la fine couche 7 déposée sur les blocs 3 est une mono-couche atomique ou une mono-couche moléculaire.

Par exemple, la fine couche 7 peut être formée d'une mono-couche atomique en Graphène, c'est-à-dire d'un feuillet en deux dimensions, composé d'atomes de carbone avec une épaisseur d'un seul atome de carbone.

Selon un autre exemple, la fine couche 7 peut être formée d'une mono-couche moléculaire de dichalcogénures de métaux de transition c'est à dire un feuillet en deux dimensions de molécules de MoS₂ ou de WS₂ ou de WSe₂ ou de MoSe₂, formant un cristal 2D, avec une épaisseur correspondant à une seule molécule.

La croissance de la fine couche 7 est réalisée par exemple par CVD (pour « Chemical Vapor Deposition »). Par exemple, lorsqu'on forme une couche de Graphène, la croissance peut être réalisée à une température comprise entre 900°C et 1200°C. En variante, on peut former la fine couche 7 par dépôt PVD (pour « Physical Vapor Déposition »).

Dans l'exemple illustré sur les figures 1B et 2B, la fine couche recouvre les blocs 3 de moulage et s'étend aussi bien sur une face supérieure 3a, que sur des faces latérales 3b, 3c des blocs 3. Selon une variante (non représentée) on peut également prévoir de réaliser la fine couche 7 uniquement sur une partie des blocs 3, en particulier sur une face latérale des blocs 3 en prévoyant de masquer d'autres zones de ces blocs 3 de moulage.

De préférence, les blocs 3 de moulage sont prévus en un matériau 4 apte à servir de catalyseur pour la croissance de la fine couche 7.

Par exemple, dans le cas où l'on souhaite faire croitre une fine couche 7 de graphène, on peut prévoir des blocs 3 en cuivre ou en platine. Selon un autre exemple, on peut prévoir des blocs 3 en oxyde de silicium (SiO₂) ou en or ou bien en saphir lorsque l'on souhaite former une fine couche 7 en MoS₂ ou en WS₂. Le matériau 4 des blocs 3 peut être du SiO₂ lorsque l'on souhaite faire croitre une fine couche de WSe₂ ou de MoSe₂.

Le choix du matériau 4 des blocs 3 peut être également dicté par celui du matériau à base duquel d'autres éléments appelés « blocs de maintien » sont prévus et qui sont destinés à soutenir la fine couche 7 lors d'un retrait ultérieur au moins partiel des blocs 3 de moulage.

Avantageusement, les blocs 9, 10 de maintien correspondent aux électrodes de source et de drain. On choisit ainsi de préférence un matériau 4 qui peut servir de catalyseur pour la fine couche 7 et peut être retiré sélectivement par rapport à celui ou ceux prévu(s) pour former les électrodes de source et de drain.

Dans l'exemple de réalisation illustré sur la figure 2C, on forme des blocs de source 9 et de drain 10 servant de blocs de maintien aux extrémités des blocs de moulage 3. Les blocs 9, 10 de source et de drain joignent ici les extrémités de plusieurs blocs de moulage 3.

Les blocs 9, 10 de source et de drain sont à base d'un matériau conducteur 8 qui, comme indiqué précédemment est apte à résister à une gravure sélective des blocs de moulage 3. Par exemple, dans le cas où les blocs de moulage 3 sont à base de cuivre, ou de saphir ou de SiO₂, on peut prévoir de réaliser les blocs 9, 10 à base d'or ou de palladium. Selon un autre exemple, on peut former des blocs 3 de moulage à base de platine ou d'or tandis que les blocs 9, 10 sont à base de Titane.

Sur les figures 1C et 2D, une étape ultérieure de formation d'un masquage 13 est représentée. Le masquage 13 est typiquement un masquage de résine et peut être réalisé par dépôt à la tournette (« spin coating »). Le masquage est déposé de sorte à recouvrir les blocs de moulage 3 ainsi que les blocs 9, 10 de source et de drain.

On effectue ensuite un retrait d'une épaisseur de masquage 13.

Le retrait partiel du masquage 13 est réalisé par exemple à l'aide d'une gravure par plasma, en particulier de type ICP (pour « Inductively Coupled Plasma ») ou RIE (pour « Reactive Ion Etching ») lorsque celui-ci est en résine.

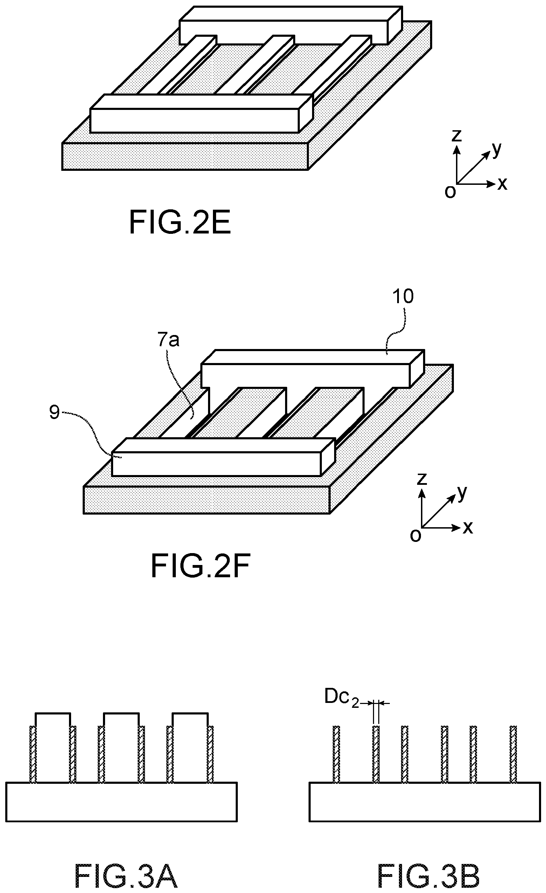

Dans l'exemple illustré sur les figures 1D et 2E, ce retrait est réalisé de sorte à dévoiler à nouveau une partie supérieure des blocs 3 de moulage, la fine couche 7 étant également retirée au niveau de cette partie des blocs 3 de moulage. Le matériau 4 formant les blocs 3 de moulage est ainsi dévoilé.

On effectue ensuite un retrait des blocs 3 de moulage tel qu'illustré sur la figure 1E. Les blocs 3 de moulage sont des blocs sacrificiels destinés à être entièrement retirés. Ce retrait est réalisé par gravure sélective du matériau 4 vis-à-vis du matériau 8 des blocs 9, 10 de maintien, ici formant des électrodes de source et de drain. La gravure des blocs 3 est typiquement réalisée par trempage de la structure dans une solution de gravure.

Des exemples de solutions de gravure utilisables sont répertoriées dans un tableau donné ci-dessous, les solutions étant associées respectivement à différents exemples de matériaux 4 catalyseur, ainsi que de matériaux 8 des blocs 9, 10 apte à résister à une gravure sélective des blocs de moulage 3.

| | | | | | | | | | |
|---|---|---|---|---|---|---|---|---|---|
| Matériau de la fine couche 7 | Graphène | | | MoS₂ | WS₂ | | | WSe₂ | MoSe₂ |
| Matériau 4 catalyseur | Cuivre (Cu) | | Platine | SiO₂ | Or | Saphir | | SiO₂ | SiO₂ |
| Solution de gravure du matériau 4 | Chlorure de Fer | Persulfate d'ammonium (NH₄)₂S₂O₈ | *Aqua regia* | Acide Fluorhydri -que (HF) | *Aqua regia* | Acide phosphori que (H₃PO₄) | Hydroxyde de sodium (NaOH) | HF | HF |
| Matériau des blocs 9, 10 de source et de drain | Or (Au) Platine (Pt) | Or Platine | Titane | Or Palladium (Pd) | Titane | Or Palladium | Or Palladium | Or Palladium | Or Palladium |

Ainsi, selon un exemple de réalisation particulier, lorsqu'on prévoit des blocs 3 de moulage en platine pour faire croitre une fine couche 7 de graphène, la solution de gravure utilisée pour retirer les blocs 3 de moulage peut être une solution d'eau régale *(aqua regia*), autrement dit un mélange d'acide chlorhydrique et d'acide nitrique. Pour permettre de résister à une telle gravure, on peut dans ce cas avoir prévu de réaliser les blocs 8, 9 en titane.

Lors du retrait des blocs 3 de moulage, les blocs 9, 10 situés à leurs extrémités, permettent d'assurer une tenue mécanique de portions 7a non-retirées de la fine couche 7.

L'exemple de réalisation donné sur la figure 2F montre la structure à l'issue de la gravure, avec les blocs 9, 10 prévus pour former des régions de source et de drain permettant de maintenir des portions 7a de la fine couche 7 qui s'étendent verticalement, autrement dit dans une direction réalisant un angle non-nul, par exemple de l'ordre de 90°, avec le plan principal du substrat 1.

On retire ensuite le reste du masquage 13. Par exemple, lorsque le masquage 13 est en résine, le retrait est typiquement effectué par trempage dans un solvant puis séchage.

Sur la figure 1F, la structure est représentée à l'issue du retrait du masquage 13. Les portions restantes 7a verticales de la fine couche 7 forment des ailettes prévues pour réaliser une structure de canal pour le transistor. La dimension critique Dc2 des ailettes 7a correspond à l'épaisseur de la fine couche 7.

Du fait du maintien des ailettes 7a par les blocs 8, 9, on peut avantageusement prévoir des ailettes 7a de dimension critique extrêmement faible. Ainsi, lorsqu'on dépose une fine couche 7 sous forme d'une mono-couche atomique (ou moléculaire), on peut ainsi obtenir une dimension critique Dc2 de l'ordre de la taille d'un atome (respectivement d'une molécule). On peut également prévoir des ailettes ayant un rapport de forme Dc2/H autrement dit de la dimension critique Dc2 sur la hauteur H (dimension mesurée parallèlement à l'axe z) importante tout en conservant une bonne tenue mécanique. Le pas de répartition des ailettes 7a dépend de celui initialement prévu pour les blocs de moulage 3 et de la dimension critique Dc1 de ces derniers.

On réalise ensuite une grille enrobante sur les ailettes 7a. Pour cela, on dépose tout d'abord une couche de matériau diélectrique 16 tel que par exemple de l'oxyde de silicium ou du HfO₂. Les ailettes 7a sont ensuite recouvertes d'un matériau 18 de grille tel que par exemple un métal tel que de l'or (figure 1G).

Pour certaines applications, en particulier pour la mise en oeuvre d'un capteur, on peut être amené à retirer certaines portions de l'empilement de grille au niveau de régions données des ailettes et dévoiler ainsi des régions de la structure de canal.

Des étapes (non représentées) de réalisation de contacts et de connexions peuvent être ensuite prévues.

Selon une variante de réalisation de l'exemple de procédé précédemment décrit, après avoir dévoilé la partie supérieure des blocs 3 de moulage on peut réaliser le retrait du masquage 13 en résine (figure 3A). Le masquage 13 est ainsi retiré avant d'effectuer le retrait des blocs 3 de moulage (figure 3B).

Dans l'un ou l'autre des exemples de réalisation qui viennent d'être décrits, les blocs 3 de moulage forment un moule dont la fine couche 7 reproduit sensiblement le relief. On peut ainsi réaliser des ailettes de forme différentes de celle précédemment décrite notamment en adaptant la forme des blocs 3 de moulage qui n'est pas nécessairement parallélépipédique.

Dans l'un ou l'autre des exemples de réalisation qui viennent d'être décrits, les blocs 3 de moulage sont entièrement retirés. On peut en variante prévoir un retrait partiel des blocs de moulage. De préférence lorsqu'on conserve une partie des blocs de moulage, on prévoit ces blocs en un matériau diélectrique afin notamment de privilégier une conduction par la structure d'ailette.

Dans l'un ou l'autre des exemples de réalisation qui viennent d'être décrits, les blocs de maintien 9, 10 ont avantageusement pour autre fonction de former des électrodes de source et de drain. On peut également prévoir de réaliser ces électrodes après formation des blocs de maintien 9, 10.

Un transistor tel que décrit précédemment peut trouver des applications dans différents types de circuits par exemple dans les circuits intégrés, les processeurs, les circuits logiques.

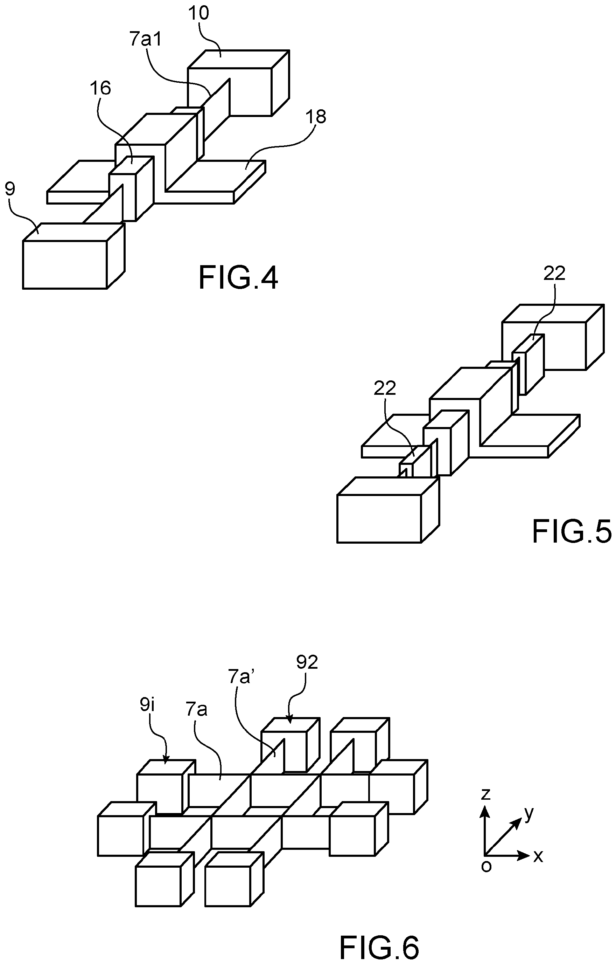

Un exemple de transistor finFET réalisé à l'aide d'un procédé du type de celui décrit précédemment est illustré sur la figure 4. L'empilement 16, 18 de grille n'est conservé que sur une portion centrale d'une ailette 7a, tandis que des régions d'extrémités 7a1 situées entre la portion centrale et les blocs 9, 10 de source et de drain sont dévoilées.

Une telle structure peut servir de base par exemple à la réalisation d'une structure de détection pour un capteur chimique et/ou biologique de sensibilité de détection améliorée et de taille réduite.

Les régions 7a1 dévoilées de l'ailette 7a peuvent ainsi servir à accueillir au moins une couche de capture 22, encore appelée « couche de fonctionnalisation » et qui est à base d'un matériau apte à absorber et/ou adsorber et/ou réagir avec au moins une espèce chimique ou biologique à détecter.

Des éléments chimiques ou biologiques à détecter sont susceptibles d'être absorbés ou adsorbées ou de réagir avec la couche de capture 22, entrainant une modification des propriétés électriques de la structure de canal.

La sensibilité de détection est d'autant améliorée que l'ailette 7a est fine.

Une ailette à base d'un cristal 2D telle que le MoS2 ou le Graphène présente un rapport surface sur volume très élevé tout en ayant de très bonnes performances électriques ce qui rend le transistor doté d'une telle structure particulièrement avantageux pour la mise en oeuvre de capteurs de haute sensibilité.

Différents types de couches de captures et leurs applications associées sont répertoriées dans le tableau ci-dessous donné à titre d'exemple.

| APPLICATIONS | COUCHE DE CAPTURE 22 | PRINCIPE PHYSIQUE DE CAPTURE |
|---|---|---|
| Détection de gaz | Matériaux poreux (Alumine poreuse, Silicium poreux, carbone amorphe nanoporeux) | Adsorption, Physiosrption, Chemisorption |
| | Oxyde métalliques (Cr₂O₃, Mn₂O₃, Co₃O₄, NiO, CuO, SrO, In₂O₃, WO₃, TiO₂, V₂O₃, Fe₂O₃) | Réaction chimique (réduction oxydation des atomes de la couche de capture) |
| Détection de molécules non-biologiques en milieu liquide | Des couches de captures semblables à celles des détecteurs de gaz peuvent s'appliquer | |
| | Polymères à empreintes moléculaires (Composé d'un monomère fonctionnel polymérisé autour de la molécule à détecter, les monomères pouvant être utilisés par exemple : Methyl methacrylate, N,N'-methylenediacrylamide, 3,5-bis(acryloylamido)benzoic acid | Reconnaissance conformationelle physique |
| Détection de molécules biologiques | Anticorps (IgG, IgM, IgE) | Reconnaissance spécifique biologique |
| | ADN (brins complémentaires d'une cible ADN à détecter) | Hybridation des brins |
| | Enzyme (Lactase, Amylase, etc...) | Reconnaissance spécifique biologique |

Selon un exemple particulier de réalisation dans lequel le capteur est un capteur de gaz, on peut prévoir une couche de capture 22 en matériau poreux tel que de l'alumine poreuse ou du silicium poreux. Selon un autre exemple particulier de réalisation dans lequel le capteur est dédié à une détection de molécules non-biologiques, on peut prévoir une couche de capture 22 en polymère tel que du Methyl méthacrylate.

Etant données les dimensions de la ou des ailettes 7a formant la structure de canal et dont la réalisation a été décrite plus haut, un tel transistor est particulièrement adapté pour détecter des quantités très faibles d'éléments biologiques et/ou chimiques, en particulier des composé présents en concentration correspondant à plusieurs ppb ou à plusieurs centièmes de ppb (ppb pour « part per billion », c'est-à-dire partie par milliard).

Un procédé tel que décrit précédemment dans lequel la dimension critique de l'ailette dépend de l'épaisseur d'une fine couche de matériau bidimensionnel et dont l'agencement dépend de la forme et de la disposition d'au moins un bloc de moulage sur lequel cette ailette est formée, peut permettre de réaliser une structure du type de celle illustrée sur la figure 6.

Cette structure comporte plusieurs ailettes 7a, 7'a orientées dans des directions différentes et non-parallèles entre elles. Dans l'exemple particulier de la figure 6, la structure comporte des ailettes 7a, 7'a disposées perpendiculairement au substrat (plan parallèle au plan [O ;x ;y ] le substrat n'étant pas représenté) et orthogonales entre elles. Les ailettes 7a, 7'a se joignent en un point de rencontre ou d'intersection. Les ailettes 7a, 7'a sont reliées à et maintenues mécaniquement respectivement par des électrodes 91, 92.

## Revendications

1. Procédé de réalisation d'un transistor dont la structure de canal comporte une ou plusieurs ailette(s), le procédé comprenant les étapes de :
- formation sur un substrat (1) d'un ou plusieurs blocs (3) appelés blocs de moulage,
- former sur lesdits un ou plusieurs blocs de moulage une fine couche (7) à base d'un matériau donné, semi-conducteur ou semi-métallique, et constitué de une à dix mono-couche(s) atomique(s) ou moléculaire(s) de cristal bidimensionnel, puis,
- former un ou plusieurs blocs (9, 10) de maintien respectivement à une ou plusieurs extrémités des blocs (3) de moulage, puis
- former un masquage (13) recouvrant les blocs (3) de moulage et les blocs (9, 10) de maintien,
- retirer partiellement le masquage (13), une épaisseur du masquage (13) étant retirée de sorte à dévoiler une partie supérieure des blocs (3) de moulage et des blocs (9, 10) de maintien, et à retirer ladite fine couche au niveau de ladite partie supérieure des blocs (3) de moulage,
- retirer lesdits un ou plusieurs blocs de moulage tout en conservant une ou plusieurs portion(s) (7a) de la fine couche s'étendant contre au moins une face latérale desdits bloc de moulage, lesdites une ou plusieurs portions (7a) conservées formant une ou plusieurs ailette(s) apte(s) à former une structure de canal du transistor, le retrait desdits blocs (3) de moulage étant réalisé par gravure sélective vis-à-vis du matériau desdits un ou plusieurs blocs 9, 10) de maintien, lesdits un ou plusieurs blocs (9, 10) de maintien étant adaptés pour assurer une tenue mécanique desdites une ou plusieurs ailette(s) lors du retrait desdits un ou plusieurs blocs de moulage, puis
- retirer le reste du masquage (13), puis
- réaliser une électrode de grille, en particulier une grille enrobante, contre lesdites une ou plusieurs ailette(s).

2. Procédé selon la revendication 1, dans lequel la fine couche (7) est formée par croissance catalytique, lesdits un ou plusieurs blocs (3) de moulage étant à base d'un matériau catalytique pour la croissance dudit matériau donné.

3. Procédé selon l'une des revendications 1 ou 2, dans lequel les blocs (9, 10) de maintien sont des électrodes de source et de drain.

4. Procédé selon la revendication 3, dans lequel les électrodes de source et de drain sont à base d'un matériau conducteur.

5. Procédé selon l'une des revendications 1 à 4, dans lequel lesdits un ou plusieurs blocs de moulage sont en un matériau diélectrique, en particulier du SiO₂.

6. Procédé selon l'une des revendications 1 à 5, dans lequel le matériau donné de la fine couche (7) est du graphène ou un chalcogénure de métal, en particulier du MoS₂ ou du WS₂ ou du WSe₂ ou du MoSe₂.

7. Procédé selon l'une des revendications 1 à 6, dans lequel la grille est une grille enrobante réalisée par formation d'un empilement de grille comprenant au moins une couche de diélectrique de grille et au moins une couche de matériau de grille, le procédé comprenant en outre le retrait localisé d'une ou plusieurs zones de la grille enrobante de sorte à dévoiler une ou plusieurs régions données desdites une ou plusieurs ailettes.

8. Procédé selon la revendication 7, dans lequel après le retrait localisé de sorte à retirer des zones de l'empilement de grille, on forme sur les régions données dévoilées desdites une ou plusieurs ailettes au moins une couche de capture (22) à base d'un matériau apte à absorber et/ou adsorber au moins une espèce chimique.

9. Procédé selon l'une des revendications 1 à 8, dans lequel ledit retrait partiel d'une épaisseur du masquage (13) et de ladite fine couche au niveau de ladite_partie supérieure des blocs (3) de moulage est effectué à l'aide d'une gravure par plasma.

10. Procédé de fabrication d'un capteur chimique ou biologique doté d'au moins un transistor comprenant la réalisation du transistor selon le procédé de l'une des revendications 1 à 9.

## Patentansprüche

1. Verfahren zur Herstellung eines Transistors, dessen Kanalstruktur eine oder mehrere Rippen aufweist, wobei das Verfahren die folgenden Schritte umfasst:
- Bilden auf einem Substrat (1) eines oder mehrerer Blöcke (3), die als Formblöcke bezeichnet werden,
- Bilden auf den einen oder mehreren Formblöcken eine dünne Schicht (7) basierend auf einem bestimmten halbleitenden oder halbmetallischen Material, das aus einer bis zehn atomaren oder molekularen Monoschicht(en) aus zweidimensionalem Kristall besteht, dann
- Bilden von einem oder mehreren Halteblöcken (9, 10) jeweils an einer oder mehreren Enden der Formblöcke (3), dann
- Bilden einer die Formblöcke (3) und die Halteblöcke (9, 10) überdeckende Maskierung (13),
- Entfernen die Maskierung (13) teilweise, wobei eine Maskierungsdicke (13) entfernt wird, um einen oberen Teil der Formblöcke (3) und der Halteblöcke (9, 10) freizulegen, und um die dünne Schicht an der Oberseite der Formblöcke (3) zu entfernen,
- Entfernen des einen oder der mehreren Formblöcke unter Beibehaltung eines oder mehrerer Abschnitte (7a) der dünnen Schicht, die sich gegen mindestens eine Seite seitlich der Formblöcke erstrecken, wobei der eine oder die mehreren beigehaltenen Abschnitte (7a) eine oder mehrere Rippen bilden, die geeignet sind, um eine Kanalstruktur des Transistors zu bilden, wobei die Entfernung der Formblöcke (3) durch selektives Ätzen in Bezug auf das Material der einen oder der mehreren Halteblöcke (9, 10) erfolgt, wobei der eine oder die mehreren Halteblöcke (9, 10) geeignet sind, eine mechanische Festigkeit der einen oder mehrerer Rippen beim Entfernen des einen oder der mehreren Formblöcke zu gewährleisten, dann
- Entfernen vom Rest der Maskierung (13) dann
- Realisieren einer Gitterelektrode, insbesondere ein Beschichtungsgitter, gegen die eine oder mehreren Rippen.

2. Verfahren nach Anspruch 1, wobei die dünne Schicht (7) durch katalytisches Wachsen gebildet wird, wobei der eine oder die mehreren Formblöcke (3) auf einem katalytischen Material für das Wachsen des gegebenen Materials basieren.

3. Verfahren nach einem der Ansprüche 1 oder 2, wobei die Halteblöcke (9, 10) Source- und Drain-Elektroden sind.

4. Verfahren nach Anspruch 3, wobei die Source- und Drain-Elektroden auf einem leitenden Material basieren.

5. Verfahren nach einem der Ansprüche 1 bis 4, wobei der eine oder die mehreren Formblöcke aus einem dielektrischen Material, insbesondere SiO2, bestehen.

6. Verfahren nach einem der Ansprüche 1 bis 5, wobei das bestimmte Material der dünnen Schicht (7) Graphen oder ein Metallchalcogenid, insbesondere MoS₂ oder WS₂ oder WSe₂ oder MoSe₂, ist.

7. Verfahren nach einem der Ansprüche 1 bis 6, wobei das Gitter ein Beschichtungsgitter ist, das durch Bilden eines Gitterstapels hergestellt ist, der mindestens eine Gitterdielektrikumsschicht und mindestens eine Gittermaterialschicht umfasst, wobei das Verfahren ferner das örtliche Entfernen eines oder mehrerer Bereiche des Beschichtungsgitters umfasst, um einen oder mehrere gegebene Bereiche der einen oder mehreren Rippen freizulegen.

8. Verfahren nach Anspruch 7, wobei nach dem örtlichen Entfernen, um Bereiche des Gitterstapels zu entfernen, auf den freigelegten gegebenen Bereichen der einen oder mehreren Rippen mindestens eine Einfangschicht (22) auf der Basis eines Materials gebildet wird, das geeignet ist, mindestens eine chemische Spezies zu absorbieren und/oder zu adsorbieren.

9. Verfahren nach einem der Ansprüche 1 bis 8, wobei das teilweise Entfernen einer Dicke der Maskierung (13) und der dünnen Schicht an dem oberen Teil der Formblöcke (3) durch Plasmaätzen erfolgt.

10. Verfahren zur Herstellung eines chemischen oder biologischen Sensors versehen mit mindestens einem Transistor, umfassend die Herstellung des Transistors nach dem Verfahren der Ansprüche 1 bis 9.

## Claims

1. Method for producing a transistor wherein the channel structure includes one or more fin(s), the method comprising the steps of:
- forming on a substrate (1) one or more blocks (3) referred to as moulding blocks,
- forming on said one or more moulding blocks a thin layer (7) based on a given semiconductor or semi-metallic material, and consisting of one to ten atomic or molecular monolayer(s) of two-dimensional crystal, then,
- forming one or more holding blocks (9, 10) respectively at one or more ends of the moulding blocks (3), then
- forming a masking (13) covering the moulding blocks (3) and the holding blocks (9, 10),
- partially removing the masking (13), a thickness of the masking (13) being removed so as to reveal a top portion of the moulding blocks (3) and the holding blocks (9, 10), and removing said thin layer at the level of the top portion of the moulding blocks (3),
- removing said one or more moulding blocks while retaining one or more portion(s) (7a) of the thin layer extending against at least one lateral face of said moulding blocks, said one or more retained portions (7a) forming one or more fin(s) suitable for forming a channel structure of the transistor, the removal of said moulding blocks (3) being carried out by selective etching with respect to the material of said one or more holding blocks (9, 10), said one or more holding blocks (9, 10) being suitable for ensuring mechanical strength of said one or more fin(s) during the removal of said one or more moulding blocks, then
- removing the rest of the masking (13), then
- producing a gate, in particular a surrounding gate, electrode against said one or more fin(s).

2. Method according to claim 1, wherein the thin layer (7) is formed by catalytic growth, said one or more moulding blocks (3) being based on a catalytic material for the growth of said given material.

3. Method according to any of the claims 1 or 2, wherein the holding blocks (9, 10) are source and drain electrodes.

4. Method according to claim 3, wherein the source and drain electrodes are based on a conductive material.

5. Method according to any of the claims 1 to 4, wherein said one or more moulding blocks are made of a dielectric material, in particular SiO₂.

6. Method according to any of the claims 1 to 5, wherein the given material of the thin layer (7) is graphene or a metal chalcogenide, in particular MoS₂ or WS₂ or WSe₂ or MoSe₂.

7. Method according to any of the claims 1 to 6, wherein the gate is a surrounding gate produced by forming a gate stack comprising at least one layer of gate dielectric layer and at least one layer of gate material, the method further comprising localised removal of one or more zones of the surrounding gate so as to reveal one or more given regions of said one or more fins.

8. Method according to claim 7, wherein after the localised removal so as to remove zones of the gate stack, at least one capture layer (22) based on a material suitable for absorbing and/or adsorbing at least one chemical species may be formed on the revealed given regions of said one or more fins.

9. Method according to any of the claims 1 to 8, wherein said partial removal of a thickness of the masking (13) and of said thin layer at the level of said top portion of the moulding blocks (3) is performed using plasma etching.

10. Method for manufacturing a chemical or biological sensor provided with at least one transistor comprising the production of the transistor according to the method according to any of the claims 1 to 9.
